(19) Europäisches Patentamt / European Patent Office / Office européen des brevets

(11) **EP 4 447 153 A1**

(12) **EUROPEAN PATENT APPLICATION**
published in accordance with Art. 153(4) EPC


(43) Date of publication:
**16.10.2024 Bulletin 2024/42**

(21) Application number: **22904645.3**

(22) Date of filing: **07.12.2022**

(51) International Patent Classification (IPC):
***H01M 4/36*** *(2006.01)* ***H01M 4/62*** *(2006.01)*
***H01M 4/525*** *(2010.01)* ***H01M 4/505*** *(2010.01)*
***H01M 10/052*** *(2010.01)* ***C23C 16/30*** *(2006.01)*
***C23C 16/455*** *(2006.01)* ***C23C 16/44*** *(2006.01)*
***H01M 4/02*** *(2006.01)*

(52) Cooperative Patent Classification (CPC):
**C23C 16/30; C23C 16/44; C23C 16/455; H01M 4/02; H01M 4/36; H01M 4/505; H01M 4/525; H01M 4/62; H01M 10/052;** Y02E 60/10

(86) International application number:
**PCT/KR2022/019769**

(87) International publication number:
**WO 2023/106816 (15.06.2023 Gazette 2023/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.12.2021 KR 20210174108**



(71) Applicant: **LG Chem, Ltd.**
**Yeongdeungpo-gu**
**Seoul 07336 (KR)**

(72) Inventors:
- **LEE, Eun Jeong**
**Daejeon 34122 (KR)**
- **KIM, Eui Tae**
**Daejeon 34122 (KR)**
- **KIM, Ki Hwan**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**


(54) **POSITIVE ELECTRODE ACTIVE MATERIAL, METHOD FOR PREPARING SAME, AND LITHIUM SECONDARY BATTERY COMPRISING SAME**


(57) The present invention relates to a positive electrode active material, wherein the present invention relates to a positive electrode active material including a particulate positive electrode active material and a coating layer formed on a surface of the particulate positive electrode active material, wherein the coating layer includes a phosphorus (P)-doped aluminum oxide, and the coating layer has a thickness of 0.1 nm to 2.0 nm, a preparation method thereof, and a positive electrode and a lithium secondary battery which include the positive electrode active material.


FIG. 1

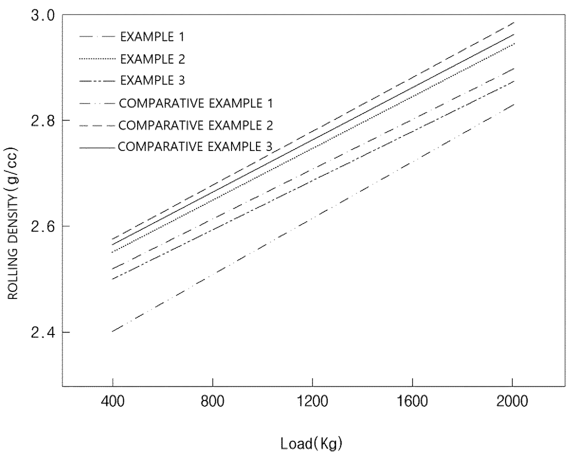


EP 4 447 153 A1

## Description

## TECHNICAL FIELD

[Cross-reference to Related Applications]

This application claims priority from Korean Patent Application No. 10-2021-0174108, filed on December 7, 2021, the disclosure of which is incorporated by reference herein.

[Technical Field]

The present invention relates to a positive electrode active material, a preparation method thereof, and a positive electrode and a lithium secondary battery which include the positive electrode active material.

## BACKGROUND ART

With the recent technological development of electric vehicles, demand for high-capacity secondary batteries is increasing, and, accordingly, research on a positive electrode using a high nickel (high Ni) positive electrode active material having excellent capacity characteristics is being actively conducted.

Decomposition of an electrolyte solution occurs on a surface of the positive electrode due to a high oxidation potential, and, accordingly, there is a problem in that a lithium secondary battery expands accompanied by gas generation. Also, there is a problem in that a structure becomes unstable in a process of intercalating and deintercalating lithium ions and the positive electrode is degraded due to dissolution of metal from the positive electrode. Particularly, since this phenomenon occurs more severely and rapidly in the high nickel positive electrode active material, a capacity remaining rate of the lithium secondary battery is rapidly reduced and it becomes a cause of reducing safety.

In order to solve this problem, methods of forming a coating layer on surfaces of particles of the high nickel positive electrode active material have been proposed. However, a positive electrode active material formed of a structure of a secondary particle, in which primary particles are aggregated, has a complicated surface shape, and pores of various sizes are distributed in the secondary particle, wherein it is not easy to form a thin and uniform coating layer up to the inside of these pores.

As a specific example, in a case in which a boron-based coating layer is formed on the positive electrode active material, it is known that a relatively uniform coating layer is formed along the surface, but, since rolling density is reduced due to glassy nature of boron, there is a problem in that energy density is reduced or particle cracking is intensified during over-rolling. Also, in a case in which an inorganic coating layer or an organic coating layer is formed on the positive electrode active material, stability of the positive electrode active material is improved, but, since lithium ion conductivity is reduced, there is a problem in that interfacial resistance and cell resistance are increased.

[Prior Art Documents]

[Patent Document]

(Patent Document 1) KR 10-2016-0026306 A

## DISCLOSURE OF THE INVENTION

## TECHNICAL PROBLEM

An aspect of the present invention provides a positive electrode active material in which a coating layer capable of preventing a decrease in rolling density and an increase in resistance while improving stability of the positive electrode active material is formed.

Another aspect of the present invention provides a positive electrode active material in which a coating layer capable of preventing degradation of output characteristics while improving lifetime and energy density of the positive electrode active material having high energy density is formed.

Another aspect of the present invention provides a method of preparing the above positive electrode active material, and a positive electrode and a lithium secondary battery which include the above positive electrode active material.

## TECHNICAL SOLUTION

In order to solve the above-described tasks, the present invention provides a positive electrode active material, a preparation method thereof, and a positive electrode and a lithium secondary battery which include the positive electrode active material.

(1) The present invention provides a positive electrode active material including a particulate positive electrode active material and a coating layer formed on a surface of the particulate positive electrode active material, wherein the coating layer includes a phosphorus (P)-doped aluminum oxide, and the coating layer has a thickness of 0.1 nm to 2.0 nm.
(2) The present invention provides the positive electrode active material of (1) above, wherein the coating layer has the thickness of 0.2 nm to 1.0 nm.
(3) The present invention provides the positive electrode active material of (1) or (2) above, wherein the phosphorus (P)-doped aluminum oxide is represented by Formula 1.

[Formula 1] $AlO_mP_n$

wherein, in Formula 1, m is in a range of 1.7 to 2.6, and n is in a range of 0.01 to 0.4.
(4) The present invention provides the positive electrode active material of (3) above, wherein m is in a range of 2.0 to 2.5, and n is in a range of 0.15 to 0.30.
(5) The present invention provides the positive electrode active material of any one of (1) to (4) above, wherein an amount of the phosphorus (P) in the coating layer is in a range of 1 wt% to 15 wt%.
(6) The present invention provides the positive electrode active material of any one of (1) to (5) above, wherein the amount of the phosphorus (P) in the coating layer is in a range of 8 wt% to 12 wt%.
(7) The present invention provides the positive electrode active material of any one of (1) to (6) above, wherein the particulate positive electrode active material includes a lithium transition metal composite oxide represented by Formula 2.

[Formula 2] $Li_aNi_bCo_cMn_dM^1_eO_2$

wherein, in Formula 2, $M^1$ is at least one selected from the group consisting of aluminum (Al), zirconium (Zr), boron (B), tungsten (W), molybdenum (Mo), chromium (Cr), niobium (Nb), magnesium (Mg), hafnium (Hf), tantalum (Ta), lanthanum (La), titanium (Ti), strontium (Sr), barium (Ba), cerium (Ce), tin (Sn), yttrium (Y), zinc (Zn), fluorine (F), phosphorus (P), and sulfur (S), and $0.9 \leq a \leq 1.2$, $0<b<1$, $0<c<1$, $0<d<1$, $0 \leq e<0.2$, and $b+c+d+e=1$.
(8) The present invention provides a method of preparing a positive electrode active material which includes steps of: loading a particulate positive electrode active material into a reaction chamber for performing atomic layer deposition (S1); and forming a coating layer on a surface of the positive electrode active material by performing a unit process including steps (S10) to (S30) a plurality of times (S2), wherein a thickness of the coating layer formed by the step (S2) is in a range of 0.1 nm to 2.0 nm.

(S10) a step of injecting a vapor-phase aluminum precursor into the reaction chamber and injecting a purge gas;
(S20) a step of injecting a vapor-phase reaction gas into the reaction chamber and injecting a purge gas; and
(S30) a step of injecting a vapor-phase phosphorus (P)-containing precursor into the reaction chamber and injecting a purge gas.

(9) The present invention provides the method of preparing a positive electrode active material of (8) above, wherein the unit process including steps (S10) to (S30) of the step (S2) is represented by Equation 1 or Equation 2.

[Equation 1]

$$[\{(S10) - (S20)\}_x - \{(S30) - (S20)\}_y]_z$$

[Equation 2]

$$[\{(S30) - (S20)\}_y - \{(S10) - (S20)\}_x]_z$$

wherein, in Equations 1 and 2,
the '-' is an order of execution of the unit process,
x is the number of repetitions of {(S10) - (S20)}, wherein x is an integer selected from 1 to 5,
y is the number of repetitions of {(S30) - (S20)}, wherein y is an integer selected from 1 to 5, and
z is the number of repetitions of [{ (S10) - (S20) $\}_x$ - {(S30) - (S20) $\}_{y]}$ or [{ (S30) - (S20)$\}_y$ - { (S10) - (S20) $\}_{x]}$, wherein z is an integer selected from 1 to 20.

(10) The present invention provides the method of preparing a positive electrode active material of (8) or (9) above, wherein the aluminum precursor is at least one selected from the group consisting of trimethylaluminium, triethylaluminium, aluminium ethoxide, and tris(diethylamino)aluminium.
(11) The present invention provides the method of preparing a positive electrode active material of any one of (8) to (10) above, wherein the reaction gas is at least one selected from the group consisting of gas-phase water vapor ($H_2O$), ozone ($O_3$), and oxygen plasma.
(12) The present invention provides the method of preparing a positive electrode active material of any one of (8) to (11) above, wherein the phosphorus (P)-containing precursor is at least one selected from the group consisting of trimethylphosphate and triethylphosphate.
(13) The present invention provides a positive electrode including the positive electrode active material of any one of (1) to (7).
(14) The present invention provides a lithium secondary battery including the positive electrode of (13).

## ADVANTAGEOUS EFFECTS

A positive electrode active material of the present invention may prevent an increase in interfacial resistance and cell resistance while improving lifetime and stability by including a phosphorus (P)-doped aluminum oxide and including a thin and uniform coating layer.
Also, since the positive electrode active material of the present invention has excellent rolling characteristics in comparison to a conventional boron-containing coating layer, it may improve energy density of a positive electrode.
Also, according to a method of preparing a positive electrode active material of the present invention, a thin and uniform coating layer may be formed on a surface of the particulate positive electrode active material.
Furthermore, since a lithium secondary battery including the positive electrode active material of the present invention has excellent capacity retention due to an improvement in cycle characteristics and has a low resistance increase rate due to degradation, a reduction in output may be suppressed.

## BRIEF DESCRIPTION OF THE DRAWINGS

FIG. 1 is a graph illustrating rolling densities for each load of positive electrode active materials prepared in Examples 1 to 3 and Comparative Examples 1 to 3 of the present invention.
FIG. 2 is a graph illustrating discharge capacities for each number of cycles of the positive electrode active materials prepared in Examples 1 to 3 and Comparative Examples 1 to 3 of the present invention.

## MODE FOR CARRYING OUT THE INVENTION

Hereinafter, the present invention will be described in more detail to allow for a clearer understanding of the present invention.
It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.
In the present invention, the expression "primary particle" denotes a smallest particle unit which is distinguished as one body when a cross section of a positive electrode active material is observed through a scanning electron microscope (SEM), wherein it may be composed of a plurality of crystallites.
In the present invention, the expression "secondary particle" denotes a secondary structure formed by aggregation of a plurality of primary particles. An average particle diameter of the secondary particle may be measured using a particle size analyzer.
The expression "average particle diameter ($D_{50}$)" in the present invention denotes a particle diameter at 50%

of cumulative distribution of volume according to the particle diameter. After dispersing measurement target powder in a dispersion medium, the dispersion medium is introduced into a commercial laser diffraction particle size measurement instrument (e.g., Microtrac S3500), a particle size distribution is calculated by measuring a difference in diffraction patterns due to a particle size when particles pass through a laser beam, and the $D_{50}$ may be measured by calculating a particle diameter at 50% of the cumulative distribution of volume according to the particle diameter using the measurement instrument.

## Positive Electrode Active Material

The present invention provides a positive electrode active material.

According to an embodiment of the present invention, the positive electrode active material includes a particulate positive electrode active material and a coating layer formed on a surface of the particulate positive electrode active material, wherein the coating layer includes a phosphorus (P)-doped aluminum oxide, and the coating layer has a thickness of 0.1 nm to 2.0 nm.

According to an embodiment of the present invention, the coating layer may be formed by atomic layer deposition according to a method of preparing a positive electrode active material which will be subsequently described, and, accordingly, the coating layer may be formed thinly and uniformly on the surface of the particulate positive electrode active material. That is, since the coating layer is formed by the atomic layer deposition, the coating layer may be formed to a uniform thickness on the entire surface of the particulate positive electrode active material. Thus, the thickness of the coating layer may be an arithmetic average thickness of the thicknesses of the total coating layers which are formed on the surface of the particulate positive electrode active material. Also, the coating layer may have the same thickness even if the coating layer on any surface of the positive electrode active material including the coating layer is checked.

According to an embodiment of the present invention, the coating layer may have a thickness of 0.1 nm or more, 0.2 nm or more, 0.3 nm or more, 0.4 nm or more, or 0.5 nm or more, and may also have a thickness of 2.0 nm or less, 1.9 nm or less, 1.8 nm or less, 1.7 nm or less, 1.6 nm or less, 1.5 nm or less, 1.4 nm or less, 1.3 nm or less, 1.2 nm or less, 1.1 nm or less, 1.0 nm or less, 0.9 nm or less, 0.8 nm or less, or 0.7 nm or less, and, since rolling characteristics are excellent while an increase in interfacial resistance is suppressed within this range, energy density of a positive electrode may be improved.

According to an embodiment of the present invention, the phosphorus (P)-doped aluminum oxide may be represented by the following Formula 1. In this case, the following Formula 1 may be a compositional formula representing an average composition of the phosphorus (P)-doped aluminum oxide.

[Formula 1] $AlO_mP_n$

In Formula 1, m is in a range of 1.7 to 2.6, and n is in a range of 0.01 to 0.4.

In order to prepare the phosphorus (P)-doped aluminum oxide included in the coating layer by using atomic layer deposition (ALD) as in the method of preparing a positive electrode active material which will be subsequently described, an aluminum precursor, in the form in which a ligand is bonded to aluminum as a central element, and a phosphorus (P)-containing precursor, in the form in which a ligand is bonded to phosphorus (P) as a central element, are required. In this case, with respect to the phosphorus (P), there are many valence electrons, and reactivity of the phosphorus (P)-containing precursor and a hydroxyl group present on a surface of a deposition object is lower than reactivity of the aluminum (Al)-containing precursor and the hydroxyl group due to steric hindrance by the ligand. Also, since the ligand bonded to the aluminum is not completely removed and some remain even after a reaction between the aluminum precursor and reactive gas (e.g., water), such steric hindrance effect is further intensified, and thus, the surface reactivity of the phosphorus (P)-containing precursor becomes even lower. Accordingly, in a case in which the phosphorus (P)-doped aluminum oxide represented by Formula 1 is formed by atomic layer deposition, efficiency (residual rate of the central element in a deposition layer) of a '(S30) - (S20)' process of forming a phosphorus (P) oxide is lower than that of a '(S10) - (S20)' process of forming an aluminum oxide in the method of preparing a positive electrode active material which will be subsequently described. Also, even if the number (y) of the '(S30) - (S20)' processes relative to the number (x) of the '(S10) - (S20)' processes is continuously increased in a unit process, when a value of n in the above compositional formula is greater than 0.4, a rate of increase of the value of n according to the increase in the number (y) of the '(S30) - (S20)' processes is significantly reduced. Thus, when considering based on an effect of increasing an amount of the phosphorus (P) in the phosphorus (P)-doped aluminum oxide, and the number of atomic layer depositions and the resulting cost efficiency, n is preferably 0.4 or less.

According to an embodiment of the present invention, in Formula 1, m may be 1.7 or more, 1.8 or more, 1.9 or more, 2.0 or more, or 2.1 or more, and may also be 2.6 or less, 2.5 or less, 2.4 or less, 2.3 or less, 2.25 or less, or 2.21 or less. Also, in Formula 1, n may be 0.01 or more, 0.05 or more, 0.10 or more, 0.15 or more, 0.16 or more, 0.17 or more, or 0.18 or more, and may also be 0.40 or less, 0.35 or less, 0.30 or less, or 0.25 or less. Since cycle characteristics

of a lithium secondary battery including the positive electrode active material are further improved within this range, capacity retention is more excellent and a resistance increase rate due to degradation is lower, and thus, a reduction in output may be suppressed.

According to an embodiment of the present invention, the amount of the phosphorus (P) in the coating layer may be 1 wt% or more, 2 wt% or more, 3 wt% or more, 4 wt% or more, 5 wt% or more, 6 wt% or more, 7 wt% or more, or 8 wt% or more, and may also be 15 wt% or less, 14 wt% or less, 13 wt% or less, or 12 wt% or less, and stability of the positive electrode active material and lifetime of the lithium secondary battery including the positive electrode active material may be improved within this range.

According to an embodiment of the present invention, the particulate positive electrode active material may include a lithium transition metal composite oxide represented by Formula 2 below.

[Formula 2] $Li_aNi_bCo_cMn_dM^1{}_eO_2$

In Formula 2, $M^1$ is at least one selected from the group consisting of aluminum (Al), zirconium (Zr), boron (B), tungsten (W), molybdenum (Mo), chromium (Cr), niobium (Nb), magnesium (Mg), hafnium (Hf), tantalum (Ta), lanthanum (La), titanium (Ti), strontium (Sr), barium (Ba), cerium (Ce), tin (Sn), yttrium (Y), zinc (Zn), fluorine (F), phosphorus (P), and sulfur (S), and $0.9 \leq a \leq 1.2$, $0<b<1$, $0<c<1$, $0<d<1$, $0 \leq e<0.2$, and $b+c+d+e=1$.

According to an embodiment of the present invention, $M^1$ in Formula 2 may be a doping element that may be included in the lithium transition metal composite oxide, and may be appropriately selected as needed.

According to an embodiment of the present invention, in Formula 2, a is a molar ratio of lithium to transition metals in the lithium transition metal composite oxide, wherein a may be 0.9 or more, 0.95 or more, or 1.0 or more, and may also be 1.2 or less, 1.1 or less, 1.07 or less, 1.05 or less, or 1.03 or less.

According to an embodiment of the present invention, in Formula 2, b, c, d, and e may be mole fractions of nickel (Ni), cobalt (Co), manganese (Mn), and doping element ($M^1$) among the transition metals, respectively. As a specific example, b is the mole fraction of the nickel (Ni) among the transition metals, wherein b may be greater than 0, 0.1 or more, 0.2 or more, 0.3 or more, 0.4 or more, 0.5 or more, 0.6 or more, 0.7 or more, or 0.8 or more, and may also be less than 1.0, 0.95 or less, 0.9 or less, or 0.85 or less. c is the mole fraction of the cobalt (Co) among the transition metals, wherein c may be greater than 0, 0.05 or more, or 0.1 or more, and may also be less than 1, 0.9 or less, 0.8 or less, 0.7 or less, 0.6 or less, 0.5 or less, 0.4 or less, 0.3 or less, or 0.2 or less. d is the mole fraction of the manganese (Mn) among the transition metals, wherein d may be greater than 0, 0.05 or more, or 0.1 or more, and may also be less than 1, 0.9 or less, 0.8 or less, 0.7 or less, 0.6 or less, 0.5 or less, 0.4 or less, 0.3 or less, or 0.2 or less. e is the mole fraction of the doping element ($M^1$) among the transition metals, wherein e may be 0, 0.01 or more, 0.02 or more, 0.03 or more, 0.04 or more, 0.05 or more, 0.06 or more, 0.07 or more, 0.08 or more, 0.09 or more, 0.10 or more, 0.11 or more, 0.12 or more, 0.13 or more, 0.14 or more, 0.15 or more, 0.16 or more, 0.17 or more, 0.18 or more, or 0.19 or more, and may also be less than 0.20, 0.19 or less, 0.18 or less, 0.17 or less, 0.16 or less, 0.15 or less, 0.14 or less, 0.13 or less, 0.12 or less, 0.11 or less, 0.10 or less, 0.09 0.08 or less, 0.07 or less, 0.06 or less, 0.05 or less, 0.04 or less, 0.03 or less, 0.02 or less, or 0.01 or less.

According to an embodiment of the present invention, the lithium transition metal composite oxide may be a high nickel-based lithium transition metal composite oxide containing 60 mol% or more of the nickel (Ni) among the transition metals. In this case, high energy density may be secured from the high amount of the nickel, and a decrease in stability of the positive electrode active material due to the high amount of the nickel from the coating layer may be prevented.

According to an embodiment of the present invention, the particulate positive electrode active material may be a secondary particle which is formed by aggregation of primary particles. As a specific example, the positive electrode active material may have an average particle diameter ($D_{50}$) of 0.5 um or more, 1 um or more, 1.5 um or more, or 2 pm or more, and may also have an average particle diameter ($D_{50}$) of 20 um or less, 18 um or less, 16 um or less, 14 um or less, 12 um or less, and, within this range, initial charge and discharge efficiency is excellent, and resistance may be reduced. Herein, the average particle diameter ($D_{50}$) of the positive electrode active material may mean an average particle diameter of the secondary particle in which the primary particles are aggregated.

According to an embodiment of the present invention, the positive electrode active material may have a rolling density measured at a load of 2,000 kgf using a powder resistivity measurement system (Loresta Co., Ltd.) of 2.85 g/cc or more, 2.86 g/cc or more, 2.87 g/cc or more, 2.88 g/cc or more, 2.89 g/cc or more, 2.90 g/cc or more, 2.91 g/cc or more, 2.92 g/cc or more, 2.93 g/cc or more, 2.94 g/cc or more, 2.95 g/cc or more, 2.96 g/cc or more, 2.97 g/cc or more, 2.98 g/cc or more, 2.99 g/cc or more, 3.00 g/cc or more, 3.01 g/cc or more, 3.02 g/cc or more, 3.03 g/cc or more cc or more, 3.04 g/cc or more, 3.05 g/cc or more, 3.06 g/cc or more, 3.07 g/cc or more, 3.08 g/cc or more, 3.09 g/cc or more, 3.10 g/cc or more, 3.11 g/cc or more, 3.12 g/cc or more, 3.13 g/cc or more, or 3.14 g/cc or more, 3.15 g/cc or more, 3.16 g/cc or more, or 3.17 g/cc or more, and may also have a rolling density measured at a load of 2,000 kgf using a powder resistivity measurement system (Loresta Co., Ltd.) of 3.50 g/cc or less, 3.40 g/cc or less, 3.30 g/cc or less, or 3.20 g/cc

or less. In a case in which the rolling density measured at a load of 2,000 kgf of the positive electrode active material is equal to or greater than the above lower limit value, since crack generation of the particles during rolling may be prevented while high energy density is obtained, an increase in interfacial resistance and cell resistance may be prevented while the lifetime and stability of the lithium secondary battery including the positive electrode active material are improved.

## Method of Preparing Positive Electrode Active Material

The present invention provides a method of preparing a positive electrode active material.

According to an embodiment of the present invention, the method of preparing a positive electrode active material may be a method for preparing the above-described positive electrode active material, and, as a specific example, may be a method for forming a coating layer which includes a phosphorus (P)-doped aluminum oxide on a surface of the positive electrode active material and has a thickness of 0.1 nm to 2.0 nm.

According to an embodiment of the present invention, the method of preparing a positive electrode active material includes steps of loading a particulate positive electrode active material into a reaction chamber for performing atomic layer deposition (ALD) (S1); and forming a coating layer on a surface of the positive electrode active material by performing a unit process including steps (S10) to (S30) a plurality of times (S2), wherein a thickness of the coating layer formed by the step (S2) may be in a range of 0.1 nm to 2.0 nm.

- (S10) a step of injecting a vapor-phase aluminum precursor into the reaction chamber and injecting a purge gas
- (S20) a step of injecting a vapor-phase reaction gas into the reaction chamber and injecting a purge gas
- (S30) a step of injecting a vapor-phase phosphorus (P)-containing precursor into the reaction chamber and injecting a purge gas

According to an embodiment of the present invention, the step (S1) is a step of loading the particulate positive electrode active material to be coated into the reaction chamber according to an ALD system, wherein it may be performed by positioning the particulate positive electrode active material obtained in a powder state in the reaction chamber. In this case, the particulate positive electrode active material may be the same as the particulate positive electrode active material previously described in the positive electrode active material.

According to an embodiment of the present invention, the atomic layer deposition is a self-limiting surface treatment method in which thin film layers are formed layer by layer to an atomic-size thickness. Unlike a chemical vapor deposition (CVD) method in which a thin film is deposited by thermal decomposition and gas-phase reaction of a reaction gas, the atomic layer deposition may be a reaction in which, after one reactant causes a chemical reaction with a surface of a substrate to cause chemical adsorption, a thin film is formed while a second or third reactant is injected to again cause chemical adsorption on the substrate. That is, the atomic layer deposition is a method of forming a thin film through chemical adsorption through periodic supply of each reactant, wherein, since a reaction between the reactant and the targeted substrate, for example, a reaction only on the surface of the particulate positive electrode active material occurs and a reaction between the reactants does not occur, deposition on an atomic scale may be possible. Also, since a thin film layer is formed on all surfaces exposed during the atomic layer deposition, a uniform coating layer may be formed on the entire surface of the particulate positive electrode active material when coating the particulate positive electrode active material according to the method of preparing a positive electrode active material of the present invention.

According to an embodiment of the present invention, the step (S2) may be a step for forming a coating layer by performing atomic layer deposition on the surface of the particulate positive electrode active material by injecting a precursor and/or a reaction gas into the reaction chamber.

According to an embodiment of the present invention, the atomic layer deposition by the step (S2) may easily form a coating layer by atomic layer deposition at a lower temperature than the chemical vapor deposition in which particles formed by a chemical reaction of gas are deposited on the surface of the substrate. As a specific example, the atomic layer deposition may be performed at a temperature of 60°C to 240°C. As a more specific example, the atomic layer deposition may be performed at a temperature of 70°C or more, 80°C or more, 90°C or more, 100°C or more, 110°C or more, 120°C or more, 130°C or more, or 140°C or more, and may also be performed at a temperature of 230°C or less, 220°C or less , 210°C or less, 200°C or less, 190°C or less, 180°C or less, 170°C or less, or 160°C or less, and smooth performance of the reaction and/or uniform formation of the coating layer may be possible within this range, and, since a high-temperature process of 400°C or higher is not required while securing the amount of the phosphorus (P) in the coating layer at an appropriate level, deterioration of physical properties of the positive electrode active material may be prevented.

According to an embodiment of the present invention, the unit process including steps (S10) to (S30) of the step (S2) may be represented by Equation 1 or Equation 2 below.

[Equation 1]

$$[\{(S10) - (S20)\}_x - \{(S30) - (S20)\}_y]_z$$

[Equation 2]

$$[\{(S30) - (S20)\}_y - \{(S10) - (S20)\}_x]_z$$

In Equations 1 and 2,

the '-' is an order of execution of the unit process, and
in Equations 1 and 2, the '-' is the order of execution of the unit process. That is, an expression such as '(S10) - (S20)' means that the step (S20) is performed following the step (S10).

Also, in Equations 1 and 2, x means the number of repetitions of {(S10) - (S20)}. x may be an integer selected from 1 to 5, as a specific example, may be an integer selected from 1 to 3, and, as a more specific example, may be 1 or 2.

Furthermore, in Equations 1 and 2, y means the number of repetitions of {(S30) - (S20)}. y may be an integer selected from 1 to 5, and, as a specific example, may be an integer selected from 1 to 3, and, as described above, since the amount of the phosphorus (P) doped in the coating layer is not increased proportionally even if the number of repetitions of {(S30) - (S20)} according to y increases, efficiency of the process may be further improved within the above range.

According to an embodiment of the present invention, the aluminum oxide may be doped with the phosphorus (P) within a desired amount range by adjusting a ratio of x to y.

Also, in Equations 1 and 2, z means the number of repetitions of $[\{(S10) - (S20)\}_x - \{(S30) - (S20)\}_y]$ or $[\{(S30) - (S20)\}_y - \{(S10) - (S20)\}_x]$. z may be an integer selected from 1 to 20, and, as a specific example, may be an integer selected from 1 to 15, 2 to 12, 3 to 10, 4 to 8, or 5 to 7, and the thickness of the coating layer may be adjusted to an appropriate level within this range.

According to an embodiment of the present invention, the step (S10) included in the unit process may be a step for atomic layer deposition of aluminum from the aluminum precursor, and the aluminum precursor may be an aluminum compound represented by Formula 3 below.

[Formula 3] $AlR^1R^2R^3$

In Formula 3, $R^1$ to $R^3$ may each be an organic group bonded to Al, and, as a specific example, $R^1$ to $R^3$ may each independently be hydrogen; an alkyl group having 1 to 10 carbon atoms; an alkoxy group having 1 to 10 carbon atoms; a halogen group; or an amino group, wherein the amino group may be a secondary amino group or tertiary amino group substituted with an alkyl group having 1 to 10 carbon atoms. As a specific example, in Formula 3, $R^1$ to $R^3$ may each independently be an alkyl group having 1 to 5 carbon atoms; an alkoxy group having 1 to 5 carbon atoms; a halogen group; or a secondary amino group or tertiary amino group substituted with an alkyl group having 1 to 5 carbon atoms. As a more specific example, in Formula 3, $R^1$ to $R^3$ may each independently be an alkyl group having 1 to 3 carbon atoms; an alkoxy group having 1 to 3 carbon atoms; a halogen group; or a tertiary amino group substituted with an alkyl group having 1 to 3 carbon atoms.

According to an embodiment of the present invention, the aluminum precursor may be at least one selected from the group consisting of trimethylaluminium, triethylaluminium, tri-n-propylaluminum, tri-n-butylaluminum, aluminium ethoxide, dimethylaluminium chloride, diethylaluminium chloride, di-n-propylaluminium chloride, di-n-butyl aluminium chloride, tris (dimethylamino)aluminium, and tris(diethylamino)aluminium. As a specific example, the aluminum precursor may be at least one selected from the group consisting of trimethylaluminium, triethylaluminium, aluminium ethoxide, and tris(diethylamino)aluminium.

According to an embodiment of the present invention, the aluminum precursor in the step (S10) may be injected into the reaction chamber in a state of being filled in a steel container maintained at 10°C to 50°C, 10°C to 40°C, 10°C to 30°C, or 15°C to 25°C. When the aluminum precursor is injected into the reaction chamber, it may be injected in a state of being vaporized by reduced pressure without using a separate carrier gas or may be injected using an inert gas as a carrier gas.

According to an embodiment of the present invention, the step (S20) may be a step for oxidizing the aluminum precursor and/or the phosphorus (P)-containing precursor from the reaction gas, wherein the reaction gas, as an oxidizing agent, may be at least one selected from the group consisting of water vapor ($H_2O$), ozone ($O_3$), and oxygen plasma.

According to an embodiment of the present invention, the reaction gas in the step (S20) may be injected into the reaction chamber in a state of being filled in a steel container maintained at 0°C to 40°C, 0°C to 30°C, 10°C to 20°C, or 12°C to 18°C. When the reaction gas is injected into the reaction chamber, it may be injected in a state of being vaporized by reduced pressure without using a separate carrier gas or may be injected using an inert gas as a carrier gas.

According to an embodiment of the present invention, the step (S30) may be a step for doping the aluminum oxide by atomic layer deposition of phosphorus from the phosphorus (P)-containing precursor, wherein the phosphorus (P)-containing precursor may be a phosphate-based compound represented by Formula 4 below.

[Formula 4]

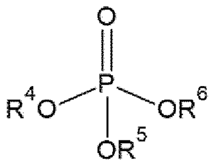

In Formula 4, $R^4$ to $R^6$ may each independently be hydrogen or an alkyl group having 1 to 10 carbon atoms. As a specific example, in Formula 4, $R^4$ to $R^6$ may each independently be an alkyl group having 1 to 8 carbon atoms. As a more specific example, in Formula 4, $R^4$ to $R^6$ may each independently be an alkyl group having 1 to 4 carbon atoms.

According to an embodiment of the present invention, the phosphorus (P)-containing precursor may be at least one selected from the group consisting of trimethylphosphate and triethylphosphate.

According to an embodiment of the present invention, the phosphorus-containing precursor in the step (S30) may be injected into the reaction chamber in a state of being filled in a steel container maintained at 50°C to 100°C, 60°C to 100°C, 70°C to 100°C, or 80°C to 90°C. When the phosphorus-containing precursor is injected into the reaction chamber, it may be injected in a state of being vaporized by reduced pressure without using a separate carrier gas or may be injected using an inert gas as a carrier gas.

According to an embodiment of the present invention, the purge gas injected during purging in the steps (S10) to (S30) may be at least one selected from inert gases, such as Ar, $N_2$, He, Ne, and/or Kr, and may preferably be Ar or $N_2$.

## Positive Electrode

The present invention provides a positive electrode including the above positive electrode active material.

According to an embodiment of the present invention, the positive electrode may include a positive electrode collector and a positive electrode active material layer formed on the positive electrode collector, wherein the positive electrode active material layer may include the above positive electrode active material.

According to an embodiment of the present invention, the positive electrode collector may include a metal having high conductivity, and is not particularly limited as long as it has no reactivity in a voltage range of the battery and the positive electrode active material layer is easily adhered thereto. As the positive electrode collector, for example, stainless steel, aluminum, nickel, titanium, fired carbon, or aluminum or stainless steel that is surface-treated with one of carbon, nickel, titanium, silver, or the like may be used. Also, the positive electrode collector may typically have a thickness of 3 um to 500 μm, and microscopic irregularities may be formed on the surface of the collector to improve the adhesion of the positive electrode active material. The positive electrode collector, for example, may be used in various shapes such as that of a film, a sheet, a foil, a net, a porous body, a foam body, a non-woven fabric body, and the like.

According to an embodiment of the present invention, the positive electrode active material layer may optionally include a conductive agent and a binder in addition to the positive electrode active material, if necessary. In this case, the positive electrode active material may be included in an amount of 80 wt% to 99 wt%, more specifically, 85 wt% to 98.5 wt% based on a total weight of the positive electrode active material layer, and excellent capacity characteristics may be obtained within this range.

According to an embodiment of the present invention, the conductive agent is used to provide conductivity to the electrode, wherein any conductive agent may be used without particular limitation as long as it has suitable electron conductivity without causing adverse chemical changes in the battery. Specific examples of the conductive agent may be graphite such as natural graphite or artificial graphite; carbon based materials such as carbon black, acetylene black, Ketjen black, channel black, furnace black, lamp black, thermal black, and carbon fibers; powder or fibers of metal such as copper, nickel, aluminum, and silver; conductive tubes such as carbon nanotubes; conductive whiskers such as zinc oxide whiskers and potassium titanate whiskers; conductive metal oxides such as titanium oxide; or conductive polymers such as polyphenylene derivatives, and any one thereof or a mixture of two or more thereof may be used. The conductive

agent may be included in an amount of 0.1 wt% to 15 wt% based on the total weight of the positive electrode active material layer.

According to an embodiment of the present invention, the binder improves the adhesion between positive electrode active material particles and the adhesion between the positive electrode active material and the current collector. Specific examples of the binder may be polyvinylidene fluoride (PVDF), polyvinylidene fluoride-hexafluoropropylene copolymer (PVDF-co-HFP), polyvinyl alcohol, polyacrylonitrile, polymethylmethacrylate, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated EPDM, a styrene-butadiene rubber (SBR), a fluorine rubber, poly acrylic acid, and a polymer having hydrogen thereof substituted with lithium (Li), sodium (Na), or calcium (Ca), or various copolymers thereof, and any one thereof or a mixture of two or more thereof may be used. The binder may be included in an amount of 0.1 wt% to 15 wt% based on the total weight of the positive electrode active material layer.

According to an embodiment of the present invention, the positive electrode may be prepared according to a typical method of preparing a positive electrode except that the above-described positive electrode active material is used. Specifically, a composition for forming a positive electrode active material layer, which is prepared by dissolving or dispersing the positive electrode active material as well as optionally the binder and the conductive agent in a solvent, is coated on the positive electrode collector, and the positive electrode may then be prepared by drying and rolling the coated positive electrode collector, or the positive electrode may be prepared by casting the composition for forming a positive electrode active material layer on a separate support and then laminating a film separated from the support on the positive electrode collector.

According to an embodiment of the present invention, the solvent may be a solvent normally used in the art, and may include dimethyl sulfoxide (DMSO), isopropyl alcohol, N-methylpyrrolidone (NMP), dimethyl formamide (DMF), acetone, or water, and any one thereof or a mixture of two or more thereof may be used. An amount of the solvent used may be sufficient if the solvent may dissolve or disperse the positive electrode active material, the conductive agent, the binder, and the dispersant in consideration of a coating thickness of a slurry and manufacturing yield, and may allow to have a viscosity that may provide excellent thickness uniformity during the subsequent coating for the preparation of the positive electrode.

According to an embodiment of the present invention, the positive electrode active material layer may have a porosity of 35% or less, as a specific example, may have a porosity of 35% or less, 34% or less, 33% or less, 32% or less, 31% or less, 30% or less, 29% or less, 28% or less, 27% or less, 26% or less, or 25% or less, and may also have a porosity of 1% or more, 5% or more, 10% or more, 15% or more, 20% or more, 21% or more, 22% or more, 23% or more, or 24% or more. The porosity of the positive electrode active material layer may be porosity after rolling, and may be a value calculated according to Equation 1 below.

[Equation 1]

$$\text{Porosity} = (1 - \text{packing density}/\text{true density}) \times 100$$

According to an embodiment of the present invention, the true density in Equation 1 may mean theoretical density of the composition for forming a positive electrode active material layer except for the solvent in a state in which there are no pores. As a specific example, the true density may be calculated by considering a weight ratio and/or true density of each material included in the composition for forming a positive electrode active material layer except for the solvent. As a more specific example, the true density may be a value calculated according to Equation 2 below.

[Equation 2]

$$\text{True density} = 1/(\sum(P_i/D_i))$$

In Equation 2, $p_i$ may mean a weight ratio of each component included in the composition for forming a positive electrode active material layer except for the solvent, and $d_i$ may mean true density of each component included in the composition for forming a positive electrode active material layer except for the solvent. As a specific example, the true density may mean a reciprocal of a value which is obtained by adding a value obtained by dividing a weight ratio of the positive electrode active material by true density of the positive electrode active material, a value obtained by dividing a weight ratio of the binder by true density of the binder, and/or a value obtained by dividing a weight ratio of the conductive agent by true density of the conductive agent. The true density, for example, may be measured with a known true density meter.

According to an embodiment of the present invention, the packing density in Equation 1 may mean density of the positive electrode active material layer after performing a rolling process. As a specific example, the packing density may be a value which is calculated by dividing an amount (loading amount) per unit area of the positive electrode active material layer by a thickness of the positive electrode active material layer by sampling an arbitrary point after rolling the positive electrode active material layer formed on the positive electrode collector. Thus, the porosity of the positive electrode active material layer may be controlled through the components of the positive electrode active material layer, the loading amount per area of the positive electrode active material layer, and/or the thickness of the positive electrode active material layer.

According to an embodiment of the present invention, in a case in which the components of the positive electrode active material layer and the loading amount per area of the positive electrode active material layer are the same, since the thinner the thickness of the positive electrode active material layer is (i.e., the smaller the pressing gap is), the lower the porosity is and the thicker the thickness of the positive electrode active material layer is (i.e., the larger the pressing gap is), the higher the porosity is, the pressing gap may be appropriately adjusted in consideration of the porosity of the desired positive electrode active material layer.

## Lithium Secondary Battery

The present invention provides a lithium secondary battery including the above positive electrode.

According to an embodiment of the present invention, the lithium secondary battery may include the positive electrode; a negative electrode; a separator disposed between the positive electrode and the negative electrode, and an electrolyte. Also, the lithium secondary battery may further optionally include a battery container accommodating an electrode assembly of the positive electrode, the negative electrode, and the separator, and a sealing member sealing the battery container.

According to an embodiment of the present invention, the negative electrode may include a negative electrode collector and a negative electrode active material layer disposed on the negative electrode collector.

According to an embodiment of the present invention, the negative electrode collector is not particularly limited as long as it has high conductivity without causing adverse chemical changes in the battery, and, for example, copper, stainless steel, aluminum, nickel, titanium, fired carbon, copper or stainless steel that is surface-treated with one of carbon, nickel, titanium, silver, or the like, and an aluminum-cadmium alloy may be used. Also, the negative electrode collector may typically have a thickness of 3 um to 500 μm, and, similar to the positive electrode collector, microscopic irregularities may be formed on the surface of the collector to improve the adhesion of a negative electrode active material. The negative electrode collector, for example, may be used in various shapes such as that of a film, a sheet, a foil, a net, a porous body, a foam body, a non-woven fabric body, and the like.

According to an embodiment of the present invention, the negative electrode active material layer may optionally include a binder and a conductive agent in addition to the negative electrode active material.

According to an embodiment of the present invention, a compound capable of reversibly intercalating and deintercalating lithium may be used as the negative electrode active material. Specific examples of the negative electrode active material may be a carbonaceous material such as artificial graphite, natural graphite, graphitized carbon fibers, and amorphous carbon; a metallic compound alloyable with lithium such as silicon (Si), aluminum (Al), tin (Sn), lead (Pb), zinc (Zn), bismuth (Bi), indium (In), magnesium (Mg), gallium (Ga), cadmium (Cd), a Si alloy, a Sn alloy, or an Al alloy; a metal oxide which may be doped and undoped with lithium such as $SiO_\beta(0<\beta<2)$, $SnO_2$, vanadium oxide, and lithium vanadium oxide; or a composite including the metallic compound and the carbonaceous material such as a Si-C composite or a Sn-C composite, and any one thereof or a mixture of two or more thereof may be used. Also, a metallic lithium thin film may be used as the negative electrode active material. Furthermore, both low crystalline carbon and high crystalline carbon may be used as the carbon material. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature sintered carbon such as petroleum or coal tar pitch derived cokes. The negative electrode active material may be included in an amount of 80 wt% to 99 wt% based on a total weight of the negative electrode active material layer.

According to an embodiment of the present invention, the binder of the negative electrode active material layer is a component that assists in the binding between the conductive agent, the active material, and the current collector, wherein the binder is typically added in an amount of 0.1 wt% to 10 wt% based on the total weight of the negative electrode active material layer. Examples of the binder may be polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated-EPDM, a styrene-butadiene rubber, a nitrile-butadiene rubber, a fluorine rubber, and various copolymers thereof.

According to an embodiment of the present invention, the conductive agent of the negative electrode active

material layer is a component for further improving conductivity of the negative electrode active material, wherein the conductive agent may be added in an amount of 10 wt% or less, preferably, 5 wt% or less based on the total weight of the negative electrode active material layer. The conductive agent is not particularly limited as long as it has conductivity without causing adverse chemical changes in the battery, and, for example, a conductive material, such as: graphite such as natural graphite or artificial graphite; carbon black such as acetylene black, Ketjen black, channel black, furnace black, lamp black, and thermal black; conductive fibers such as carbon fibers or metal fibers; fluorocarbon; metal powder such as aluminum powder and nickel powder; conductive whiskers such as zinc oxide whiskers and potassium titanate whiskers; conductive metal oxide such as titanium oxide; or polyphenylene derivatives, may be used.

According to an embodiment of the present invention, the negative electrode may be prepared by coating a composition for forming a negative electrode active material layer, which is prepared by dissolving or dispersing optionally the binder and the conductive agent as well as the negative electrode active material in a solvent, on the negative electrode collector and drying the coated negative electrode collector, or may be prepared by casting the composition for forming a negative electrode active material layer on a separate support and then laminating a film separated from the support on the negative electrode collector.

According to an embodiment of the present invention, the separator separates the negative electrode and the positive electrode and provides a movement path of lithium ions, wherein any separator may be used as the separator without particular limitation as long as it is typically used in a lithium secondary battery, and particularly, a separator having high moisture-retention ability for an electrolyte as well as low resistance to the transfer of electrolyte ions may be used. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous nonwoven fabric, for example, a nonwoven fabric formed of high melting point glass fibers or polyethylene terephthalate fibers may be used. Furthermore, a coated separator including a ceramic component or a polymer material may be used to secure heat resistance or mechanical strength, and the separator having a single layer or multilayer structure may be optionally used.

According to an embodiment of the present invention, the electrolyte may include an organic liquid electrolyte, an inorganic liquid electrolyte, a solid polymer electrolyte, a gel-type polymer electrolyte, a solid inorganic electrolyte, or a molten-type inorganic electrolyte which may be used in the preparation of the lithium secondary battery, but the present invention is not limited thereto. As a specific example, the electrolyte may include an organic solvent and a lithium salt.

According to an embodiment of the present invention, any organic solvent may be used as the organic solvent without particular limitation so long as it may function as a medium through which ions involved in an electrochemical reaction of the battery may move. Specifically, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; or a carbonate-based solvent such as dimethyl carbonate (DMC), diethyl carbonate (DEC), methylethyl carbonate (MEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond aromatic ring or ether bond); amides such as dimethylformamide; dioxolanes such as 1,3-dioxolane; or sulfolanes may be used as the organic solvent. Among these solvents, the carbonate-based solvent is preferable, and a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) is more preferable.

According to an embodiment of the present invention, the lithium salt may be used without particular limitation as long as it is a compound capable of providing lithium ions used in the lithium secondary battery. Specifically, an anion of the lithium salt may be at least one selected from the group consisting of $F^-$, $Cl^-$, $Br^-$, $I^-$, $NO_3^-$, $N(CN)_2^-$, $BF_4^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$, and $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$ may be used as the lithium salt. The lithium salt may be used in a concentration range of 0.1 M to 2.0 M. If the concentration of the lithium salt is included within the above range, since the electrolyte may have appropriate conductivity and viscosity, excellent performance of the electrolyte may be obtained and lithium ions may effectively move.

According to an embodiment of the present invention, in order to improve life characteristics of the battery, suppress the reduction in battery capacity, and improve discharge capacity of the battery, at least one additive, for example, a halo-alkylene carbonate-based compound such as difluoroethylene carbonate, pyridine, triethylphosphite, triethanolamine, cyclic ether, ethylenediamine, n-glyme, hexaphosphorictriamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte in addition to the above electrolyte components. In this case, the additive may be included in an amount of 0.1 wt% to 5 wt% based on a total weight of the electrolyte.

Since the lithium secondary battery including the positive electrode active material according to the present invention stably exhibits excellent capacity characteristics, output characteristics, and life characteristics, the lithium secondary battery is suitable for portable devices, such as mobile phones, notebook computers, and digital cameras, and electric cars such as hybrid electric vehicles (HEVs) and electric vehicles (EVs).

A shape of the lithium secondary battery of the present invention is not particularly limited, but a cylindrical type using a can, a prismatic type, a pouch type, or a coin type may be used.

The lithium secondary battery according to the present invention may not only be used in a battery cell that is used as a power source of a small device, but may also be used as a unit cell in a medium and large sized battery module including a plurality of battery cells.

Thus, according to an embodiment of the present invention, a battery module including the lithium secondary battery as a unit cell and a battery pack including the battery module are provided.

According to an embodiment of the present invention, the battery module or the battery pack may be used as a power source of at least one medium and large sized device of a power tool; electric cars including an electric vehicle (EV), a hybrid electric vehicle, and a plug-in hybrid electric vehicle (PHEV); or a power storage system.

Hereinafter, examples of the present invention will be described in detail in such a manner that it may easily be carried out by a person with ordinary skill in the art to which the present invention pertains. The invention may, however, be embodied in many different forms and should not be construed as being limited to the examples set forth herein.

## Examples and Comparative Examples

### Example 1

A particulate positive electrode active material (LG Chem, GL80), which was a secondary particle having an average particle diameter ($D_{50}$) of 10.9 um and had an average composition of $LiNi_{0.8}Mn_{0.1}Co_{0.1}O_2$, was loaded into an ALD system (NCDTech Co., Ltd., Lucida C200-PL) in which a substrate temperature was maintained at 150°C. Subsequently, as a unit process (ALD first unit process), the following (S11) process, (S21) process, and (S31) process were performed in the order of the following Equation 1-1, and the ALD first unit process was performed a total of 6 times to prepare a positive electrode active material coated with a phosphorus (P)-doped aluminum oxide.

[Equation 1-1]

(S11) - (S21) - (S31) - (S21)

(S11) Trimethylaluminum, as an aluminum precursor, was injected into the ALD system for 1 second. The aluminum precursor was used by being filled in a steel container maintained at 20°C, and the aluminum precursor vaporized by reduced pressure was injected into the system without using a separate carrier gas. Subsequently, purging was performed for 50 seconds using Ar as an inert gas.

(S21) Water vapor, as a reaction gas, was injected into the ALD system for 1 second. The reaction gas was used by being filled in a steel container maintained at 14°C, and the reaction gas vaporized by reduced pressure was injected into the system without using a separate carrier gas. Subsequently, purging was performed for 50 seconds using Ar as an inert gas.

(S31) Trimethylphosphate, as a phosphorus (P)-containing precursor, was injected into the ALD system for 1 second. The phosphorus-containing precursor was used by being filled in a steel container maintained at 85°C, and the phosphorus-containing precursor vaporized by reduced pressure was injected into the system without using a separate carrier gas. Subsequently, purging was performed for 50 seconds using Ar as an inert gas.

### Example 2

A positive electrode active material coated with a phosphorus (P)-doped aluminum oxide was prepared in the same manner as in Example 1 except that, in Example 1, as a unit process (ALD third unit process), the following (S11) process, (S21) process, and (S31) process were performed in the order of the following Equation 1-3, and the ALD third unit process was performed a total of 6 times.

[Equation 1-3]

$$(S11) - (S21) - \{(S31) - (S21)\}_3$$

**Example 3**

A positive electrode active material coated with a phosphorus (P)-doped aluminum oxide was prepared in the same manner as in Example 1 except that, in Example 1, as a unit process (ALD fourth unit process), the following (S11) process, (S21) process, and (S31) process were performed in the order of the following Equation 1-4, and the ALD fourth unit process was performed a total of 2 times.

[Equation 1-4]

$$\{(S11) - (S21)\}_3 - (S31) - (S21)$$

**Comparative Example 1**

A particulate positive electrode active material (LG Chem, GL80), which was a secondary particle having an average particle diameter ($D_{50}$) of 10.9 um and had an average composition of $LiNi_{0.8}Mn_{0.1}Co_{0.1}O_2$, was dried at 130°C for 5 hours using a vacuum oven without a separate coating process to prepare a positive electrode active material.

**Comparative Example 2**

A positive electrode active material coated with an aluminum oxide was prepared in the same manner as in Example 1 except that, in Example 1, as a unit process (ALD fifth unit process), the following (S11) process and (S21) process were performed in the order of the following Equation 3, and the ALD fifth unit process was performed a total of 6 times.

[Equation 3]

$$(S11) - (S21)$$

**Comparative Example 3**

A positive electrode active material coated with a phosphorus (P)-doped aluminum oxide was prepared in the same manner as in Example 1 except that, in Example 1, as a unit process (ALD third unit process), the following (S11) process, (S21) process, and (S31) process were performed in the order of the following Equation 1-3, and the ALD third unit process was performed a total of 30 times.

[Equation 1-3]

$$(S11) - (S21) - \{(S31) - (S21)\}_3$$

**Experimental Examples**

**Experimental Example 1: Confirmation of Components of Aluminum Oxide Coating Layer According to with or without Phosphorus (P) Doping**

A silicon wafer was loaded into an ALD system (NCDTech Co., Ltd., Lucida C200-PL) in which a substrate temperature was maintained at 150°C. Subsequently, as unit processes (Equation 1-1: ALD first unit process; Equation 1-2: ALD second unit process; Equation 1-3: ALD third unit process; Equation 1-4: ALD fourth unit process; Equation 3: ALD fifth unit process), the following (S11) process, (S21) process, and (S31) process were performed in the order of the following Equation 1-1, Equation 1-2, Equation 1-3, Equation 1-4, and Equation 3, respectively. In this case, the ALD first unit process to the ALD fifth unit process were each performed so that a '(S11) - (S21)' process may be performed

a total of 300 times. That is, the ALD first through ADL third unit processes and the ALD fifth unit process were performed a total of 300 times, and the ALD fourth unit process was performed a total of 100 times to form atomic layer deposition films corresponding to aluminum oxide coating layers doped or undoped with phosphorus (P).

[Equation 1-1]

(S11) - (S21) - (S31) - (S21)

[Equation 1-2]

$(S11) - (S21) - \{(S31) - (S21)\}_2$

[Equation 1-3]

$(S11) - (S21) - \{(S31) - (S21)\}_3$

[Equation 1-4]

$\{(S11) - (S21)\}_3 - (S31) - (S21)$

[Equation 3]

(S11) - (S21)

(S11) Trimethylaluminum, as an aluminum precursor, was injected into the ALD system for 1 second. The aluminum precursor was used by being filled in a steel container maintained at 20°C, and the aluminum precursor vaporized by reduced pressure was injected into the system without using a separate carrier gas. Subsequently, purging was performed for 50 seconds using Ar as an inert gas.

(S21) Water vapor, as a reaction gas, was injected into the ALD system for 1 second. The reaction gas was used by being filled in a steel container maintained at 14°C, and the reaction gas vaporized by reduced pressure was injected into the system without using a separate carrier gas. Subsequently, purging was performed for 50 seconds using Ar as an inert gas.

(S31) Trimethylphosphate, as a phosphorus (P)-containing precursor, was injected into the ALD system for 1 second. The phosphorus-containing precursor was used by being filled in a steel container maintained at 85°C, and the phosphorus-containing precursor vaporized by reduced pressure was injected into the system without using a separate carrier gas. Subsequently, purging was performed for 50 seconds using Ar as an inert gas.

Thereafter, a thickness of the deposition film was measured by using an ellipsometer (J. A. Woolam Co., MK-2000) by fitting psi and delta measurement values from 380 nm to 780 nm using a Cauchy model, components of the deposition film were analyzed by irradiating the film with a monochromatic Al K-α X-ray source using X-ray photoelectron spectroscopy (XPS) (K-Alpha+, Thermo Fisher Scientific Inc.) and presented in in Table 1 below, and, based on the corresponding analysis results, composition ratios of phosphorus (P)-doped or undoped aluminum oxides represented by Formula 1 for the positive electrode active materials coated with the phosphorus (P)-doped or undoped aluminum oxides, which were prepared in Examples 1 to 3 and Comparative Examples 1 to 3, are presented in Table 2 below.

[Table 1]

| Category | | Ellipsometer analysis | | XPS analysis | | |
|---|---|---|---|---|---|---|
| Unit process type | The number of repetitio ns of the unit process | Thickn ess (nm) | Deposition thickness per unit process (nm) | Al (wt%) | O (wt%) | P (wt%) |
| ALD first unit process | 300 | 28.87 | 0.096 | 40.8 | 50.9 | 8.2 |

(continued)

| Category | | Ellipsometer analysis | | XPS analysis | | |
|---|---|---|---|---|---|---|
| Unit process type | The number of repetitio ns of the unit process | Thickn ess (nm) | Deposition thickness per unit process (nm) | Al (wt%) | O (wt%) | P (wt%) |
| ALD second unit process | 300 | 29.99 | 0.099 | 40.0 | 50.4 | 9.5 |
| ALD third unit process | 300 | 31.40 | 0.105 | 38.5 | 50.4 | 11.1 |
| ALD fourth unit process | 100 | 30.60 | 0.306 | 46.7 | 49.1 | 4.2 |
| ALD fifth unit process | 300 | 35.55 | 0.119 | 53.4 | 46.6 | 0 |

[Table 2]

| Category | | Examples | | | Comparative Examples | | |
|---|---|---|---|---|---|---|---|
| | | 1 | 2 | 3 | 1 | 2 | 3 |
| $AlO_mP_n$ | m | 2.10 | 2.21 | 1.77 | Coating × | 1.47 | 2.21 |
| | n | 0.18 | 0.25 | 0.08 | Coating × | 0 | 0.25 |

As illustrated in Table 1, in a case in which atomic layer depositions were performed according to the ALD first unit process, the ALD second unit process, and the ADL third unit process, it may be confirmed that the deposition films were formed to a deposition thickness of about 0.1 nm per unit process, and, in a case in which atomic layer deposition was performed according to the ALD fourth unit process, it may be confirmed that the deposition film was formed to a deposition thickness of about 0.3 nm per unit process. Also, it may be confirmed that each deposition film included phosphorus (P) in an amount of 4.2 wt% to 11.1 wt%. In a case in which atomic layer deposition was performed according to the ALD fifth unit process, it may be confirmed that the deposition film was formed to a deposition thickness of about 0.1 nm per unit process, and it may be confirmed that the deposition film did not include phosphorus (P).

Accordingly, with respect to the positive electrode active material prepared in Example 1, since the ALD first unit process was performed a total of 6 times, it may be expected that a coating layer having a thickness of 0.576 nm was formed on a surface of the particulate positive electrode active material, and an amount of phosphorus (P) in the corresponding coating layer was 8.2 wt%.

Also, with respect to the positive electrode active material prepared in Example 2, since the ALD third unit process was performed a total of 6 times, it may be expected that a coating layer having a thickness of 0.630 nm was formed on a surface of the particulate positive electrode active material, and an amount of phosphorus (P) in the corresponding coating layer was 11.1 wt%.

Furthermore, with respect to the positive electrode active material prepared in Example 3, since the ALD fourth unit process was performed a total of 2 times, it may be expected that a coating layer having a thickness of 0.612 nm was formed on a surface of the particulate positive electrode active material, and an amount of phosphorus (P) in the corresponding coating layer was 4.2 wt%.

Also, with respect to the positive electrode active material prepared in Comparative Example 2, since the ALD fifth unit process was performed a total of 6 times, it may be expected that a coating layer having a thickness of 0.714 nm was formed on a surface of the particulate positive electrode active material, and phosphorus (P) was not included in the corresponding coating layer.

Furthermore, with respect to the positive electrode active material prepared in Comparative Example 3, since the ALD third unit process was performed a total of 30 times, it may be expected that a coating layer having a thickness of 3.150 nm was formed on a surface of the particulate positive electrode active material, and an amount of phosphorus (P) in the corresponding coating layer was 11.1 wt%.

**Experimental Example 2: Rolling Density Measurement**

Rolling densities were measured for each of the positive electrode active materials prepared in Examples 1 to 3 and Comparative Examples 1 to 3 at loads of 400 kgf, 800 kgf, 1,200 kgf, 1,600 kgf, and 2,000 kgf using a powder resistivity measurement system (Loresta Co., Ltd.) and presented in FIG. 1, and the rolling densities at a load of 2,000 kg are presented in Table 2 below.

[Table 3]

| Category | Examples | | | Comparative Examples | | |
|---|---|---|---|---|---|---|
| | 1 | 2 | 3 | 1 | 2 | 3 |
| Rolling density (g/cc) | 2.899 | 2.947 | 2.875 | 2.833 | 2.985 | 2.964 |

As illustrated in Table 3, in a case in which the coating layer formed on the surface of the particulate positive electrode active material was included, it may be confirmed that all of the rolling densities were improved in comparison to that of Comparative Example 1 not including the coating layer.

**Experimental Example 3: Charge and Discharge Evaluation**

Each of the positive electrode active materials prepared in Examples 1 to 3 and Comparative Examples 1 to 3, carbon black (Denka Company Limited, Denka Black) as a conductive agent, and PVdF (Kureha Corporation, KF1300), as a binder, were added in a weight ratio of 97.5:1:1.5 (positive electrode active material:conductive agent:binder) to a solvent (DAEJUNG CHEMICALS & METALS CO., LTD., N-methylpyrrolidone (NMP)) to prepare a composition for forming a positive electrode active material layer.

One surface of a 12 um thick aluminum foil current collector was coated with each of the above-prepared compositions for forming a positive electrode active material layer and dried at 135°C for 3 hours to form a positive electrode active material layer. Subsequently, the positive electrode active material layer was rolled by a roll pressing method, and, after the rolling, a positive electrode having a porosity of the positive electrode active material layer of 25% was prepared.

After disposing a polypropylene separator (W-SCOPE Corporation, WL20C) between each of the above-prepared positive electrodes and a 300 um thick lithium metal thin film as a negative electrode, a coin-type half-cell was prepared by using an organic electrolyte solution of ethylene carbonate(EC)/dimethyl carbonate(DMC)/$LiPF_6$ (Merck Battery grade, EC/DMC=1/1, 1M $LiPF_6$).

The above-prepared coin-type half-cells were activated, and then charged and discharged. Specifically, 30 cycles of charge/discharge were performed under the conditions of a charge end voltage of 4.4 V, a discharge end voltage of 2.5 V, and 0.3 C/0.3 C at 45°C to measure discharge capacities in a first cycle and a $30^{th}$ cycle and discharge resistance based on 60 seconds, and discharge capacity retention and discharge resistance increase rate (based on 60 seconds) in the $30^{th}$ cycle relative to the first cycle discharge capacity and discharge resistance were measured and presented in Table 4 below.

[Table 4]

| Category | Examples | | | Comparative Examples | | |
|---|---|---|---|---|---|---|
| | 1 | 2 | 3 | 1 | 2 | 3 |
| First cycle discharge capacity (mAh/g) | 214.19 | 214.23 | 213.11 | 213.09 | 213.83 | 205.84 |
| $30^{th}$ cycle discharge capacity (mAh/g) | 203.33 | 208.17 | 201.85 | 193.24 | 196.73 | 193.11 |
| First cycle discharge resistance (Ω, based on 60 seconds) | 15.61 | 16.50 | 16.26 | 15.98 | 16.80 | 26.13 |
| $30^{th}$ cycle discharge resistance (Ω, based on 60 seconds) | 19.13 | 21.37 | 25.12 | 50.76 | 32.95 | 69.42 |

(continued)

| Category | | Examples | | | Comparative Examples | | |
|---|---|---|---|---|---|---|---|
| | | 1 | 2 | 3 | 1 | 2 | 3 |
| 30 cycles of high-temperature (45°C) charge and discharge | Discharge capacity retention (%) | 94.9 | 97.2 | 94.7 | 90.7 | 92.0 | 93.8 |
| | Discharge resistance increase rate (%) | 122.5 | 129.5 | 154.5 | 317.6 | 196.1 | 265.6 |

As illustrated in Table 4, in a case in which the positive electrode active materials prepared in Examples 1 to 3 of the present invention were included, it may be confirmed that capacity retentions were improved and resistance increase rates were significantly reduced in comparison to a case where the positive electrode active material of Comparative Example 1 without a coating layer was included.

Particularly, from the results of Examples 1 and 2 and Example 3, in a case in which the amount of the phosphorus (P) in the aluminum oxide included in the coating layer was secured at a certain level as in Examples 1 and 2, it may be confirmed that the capacity retentions were further improved, and the resistance increase rates were further reduced.

In contrast, in a case in which the positive electrode active material prepared in Comparative Example 2, in which the coating layer was formed only with aluminum oxide without doping with phosphorus (P), was included, capacity retention and resistance increase rate were improved in comparison to a case where the positive electrode active material of Comparative Example 1 without a coating layer was included, but it did not show a significant improvement as in the case that the positive electrode active materials prepared in Examples 1 to 3 were included.

Also, in a case in which the positive electrode active material of Comparative Example 3, in which the coating layer having a thickness of 3.150 nm was formed on the surface of the particulate positive electrode active material by performing the ALD third unit process 30 times, was included, it may be confirmed that the first cycle discharge capacity was rapidly decreased due to the increased thickness of the coating layer, but an improvement in the resistance increase rate was rather insignificant.

From these results, it may be confirmed that the positive electrode active material of the present invention may prevent the increase in interfacial resistance and cell resistance while improving the lifetime and stability by including the phosphorus (P)-doped aluminum oxide formed by the atomic layer deposition and including the thin and uniform coating layer, and, accordingly, it may be confirmed that, since the cycle characteristics of the lithium secondary battery were improved, the capacity retention was excellent and the resistance increase rate due to degradation was low, and thus, the reduction in output may be suppressed.

## Claims

1. A positive electrode active material comprising a particulate positive electrode active material and a coating layer formed on a surface of the particulate positive electrode active material,

   wherein the coating layer comprises a phosphorus (P)-doped aluminum oxide, and
   the coating layer has a thickness of 0.1 nm to 2.0 nm.

2. The positive electrode active material of claim 1, wherein the coating layer has the thickness of 0.2 nm to 1.0 nm.

3. The positive electrode active material of claim 1, wherein the phosphorus (P)-doped aluminum oxide is represented by Formula 1:

   [Formula 1] $AlO_mP_n$

   wherein, in Formula 1, m is in a range of 1.7 to 2.6, and n is in a range of 0.01 to 0.4.

4. The positive electrode active material of claim 3, wherein m is in a range of 2.0 to 2.5, and n is in a range of 0.15 to 0.30.

5. The positive electrode active material of claim 1, wherein an amount of the phosphorus (P) in the coating layer is in a range of 1 wt% to 15 wt%.

**6.** The positive electrode active material of claim 1, wherein an amount of the phosphorus (P) in the coating layer is in a range of 8 wt% to 12 wt%.

**7.** The positive electrode active material of claim 1, wherein the particulate positive electrode active material comprises a lithium transition metal composite oxide represented by Formula 2: [Formula 2] $Li_aNi_bCo_cMn_dM^1_eO_2$ wherein, in Formula 2,

$M^1$ is at least one selected from the group consisting of Al, Zr, B, W, Mo, Cr, Nb, Mg, Hf, Ta, La, Ti, Sr, Ba, Ce, Sn, Y, Zn, F, P, and S, and
$0.9 \le a \le 1.2$, $0<b<1$, $0<c<1$, $0<d<1$, $0 \le e<0.2$, and $b+c+d+e=1$.

**8.** A method of preparing a positive electrode active material, the method comprising steps of:

loading a particulate positive electrode active material into a reaction chamber for performing atomic layer deposition (S1); and
forming a coating layer on a surface of the positive electrode active material by performing a unit process including steps (S10) to (S30) a plurality of times (S2),
wherein a thickness of the coating layer formed by the step (S2) is in a range of 0.1 nm to 2.0 nm:

(S10) a step of injecting a vapor-phase aluminum precursor into the reaction chamber and injecting a purge gas;
(S20) a step of injecting a vapor-phase reaction gas into the reaction chamber and injecting a purge gas; and
(S30) a step of injecting a vapor-phase phosphorus (P)-containing precursor into the reaction chamber and injecting a purge gas.

**9.** The method of claim 8, wherein the unit process including steps (S10) to (S30) of the step (S2) is represented by Equation 1 or Equation 2:

[Equation 1]

$$[\{(S10) - (S20)\}_x - \{(S30) - (S20)\}_y]_z$$

[Equation 2]

$$[\{(S30) - (S20)\}_y - \{(S10) - (S20)\}_x]_z$$

wherein, in Equations 1 and 2,

the '-' is an order of execution of the unit process,
x is the number of repetitions of {(S10) - (S20)}, wherein x is an integer selected from 1 to 5,
y is the number of repetitions of {(S30) - (S20)}, wherein y is an integer selected from 1 to 5, and
z is the number of repetitions of $[\{(S10) - (S20)\}_x - \{(S30) - (S20)\}_y]$ or $[\{(S30) - (S20)\}_y - \{(S10) - (S20)\}_x]$, wherein z is an integer selected from 1 to 20.

**10.** The method of claim 8, wherein the aluminum precursor is at least one selected from the group consisting of trimethylaluminium, triethylaluminium, aluminium ethoxide, and tris(diethylamino)aluminium.

**11.** The method of claim 8, wherein the reaction gas is at least one selected from the group consisting of gas-phase water vapor ($H_2O$), ozone ($O_3$), and oxygen plasma.

**12.** The method of claim 8, wherein the phosphorus (P)-containing precursor is at least one selected from the group consisting of trimethylphosphate and triethylphosphate.

**13.** A positive electrode comprising the positive electrode active material of any one of claims 1 to 7.

**14.** A lithium secondary battery comprising the positive electrode of claim 13.

FIG. 1

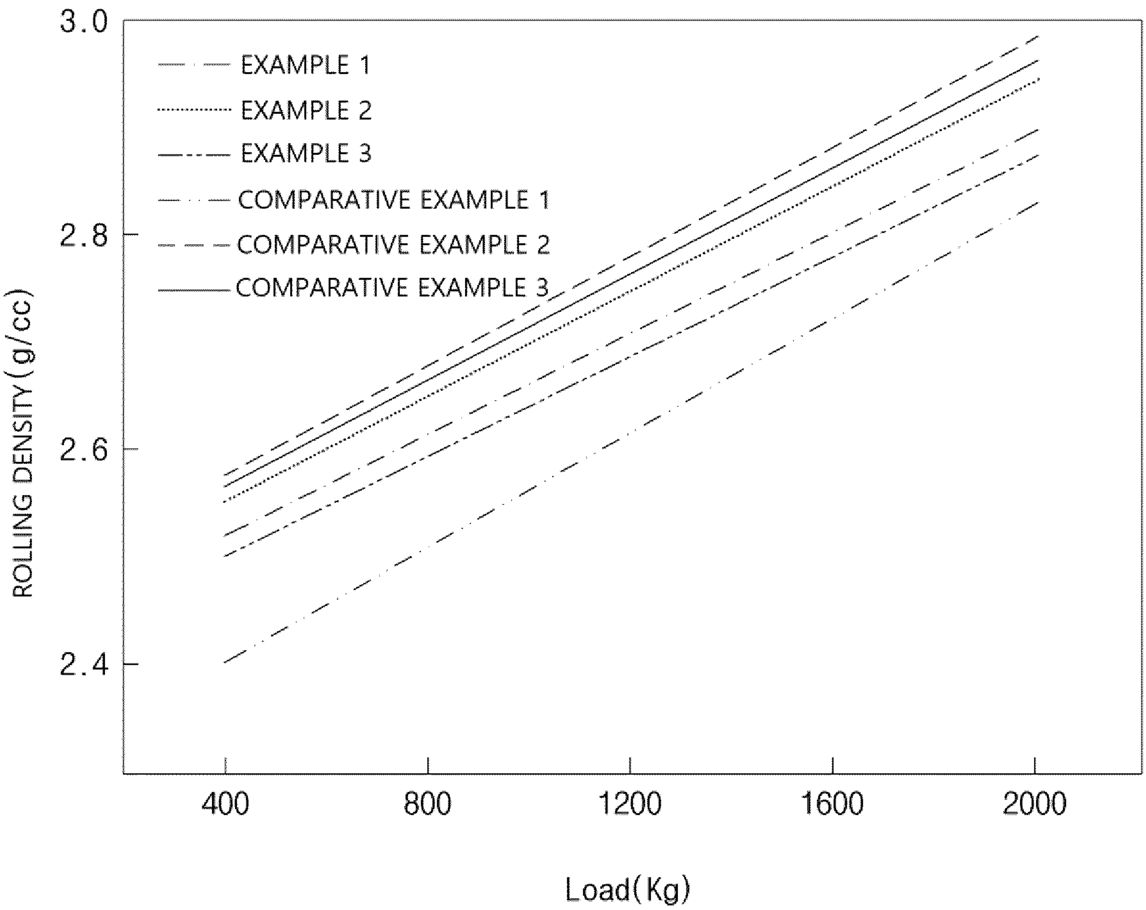
3.0
2.8
2.6
2.4
ROLLING DENSITY (g/cc)
EXAMPLE 1
EXAMPLE 2
EXAMPLE 3
COMPARATIVE EXAMPLE 1
COMPARATIVE EXAMPLE 2
COMPARATIVE EXAMPLE 3
400
800
1200
1600
2000
Load(Kg)

FIG. 2

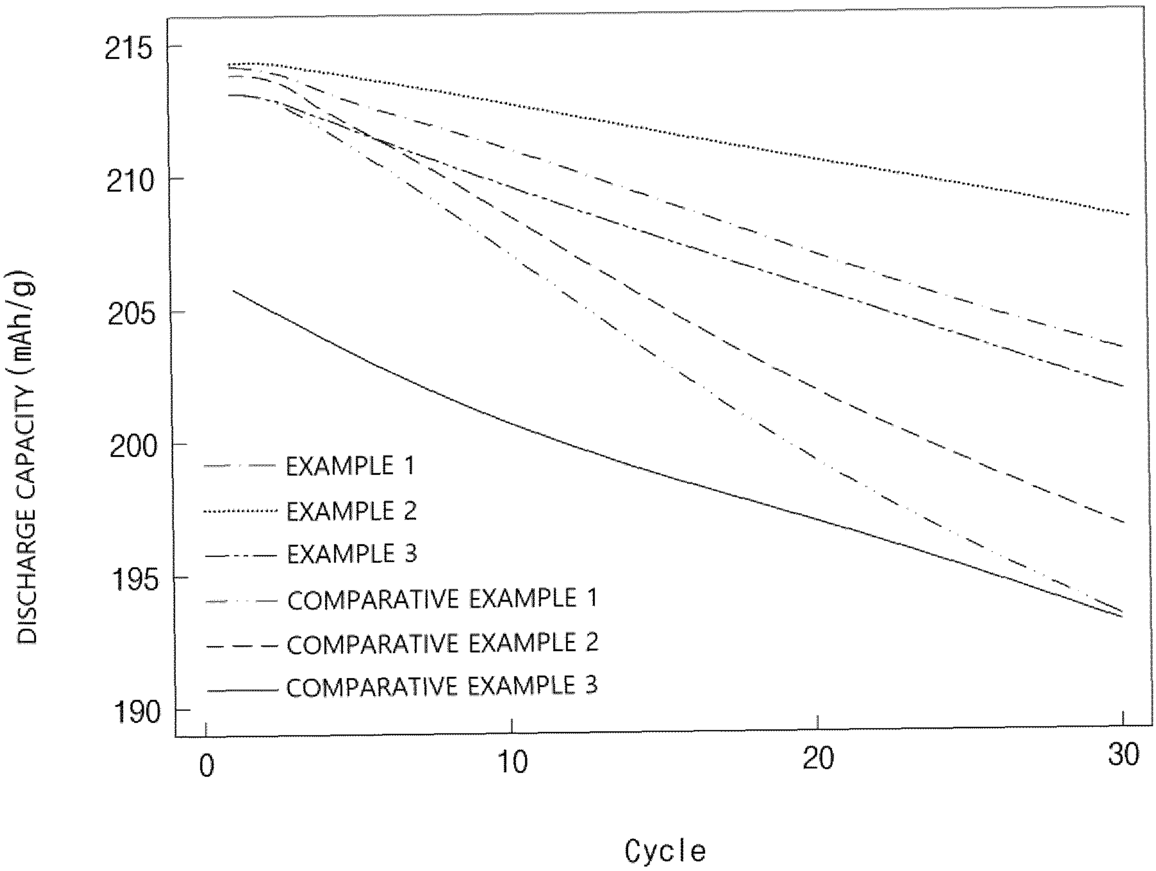
215
210
205
200
195
190
DISCHARGE CAPACITY (mAh/g)
EXAMPLE 1
EXAMPLE 2
EXAMPLE 3
COMPARATIVE EXAMPLE 1
COMPARATIVE EXAMPLE 2
COMPARATIVE EXAMPLE 3
0
10
20
30
Cycle

**INTERNATIONAL SEARCH REPORT**

International application No. **PCT/KR2022/019769**

**A. CLASSIFICATION OF SUBJECT MATTER**

**H01M 4/36**(2006.01)i; **H01M 4/62**(2006.01)i; **H01M 4/525**(2010.01)i; **H01M 4/505**(2010.01)i; **H01M 10/052**(2010.01)i; **C23C 16/30**(2006.01)i; **C23C 16/455**(2006.01)i; **C23C 16/44**(2006.01)i; **H01M 4/02**(2006.01)i

According to International Patent Classification (IPC) or to both national classification and IPC

**B. FIELDS SEARCHED**

Minimum documentation searched (classification system followed by classification symbols)

H01M 4/36(2006.01); C23C 16/06(2006.01); C23C 16/44(2006.01); C23C 16/448(2006.01); H01L 21/205(2006.01); H01M 10/052(2010.01); H01M 4/04(2006.01); H01M 4/139(2010.01); H01M 4/1391(2010.01); H01M 4/38(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 인 (P, phosphate), 산화알루미늄 (aluminium oxide), 코팅층 (coating layer), 양극 (cathode), 도핑 (doping), 원자층 증착 (atomic layer deposition, ALD)

**C. DOCUMENTS CONSIDERED TO BE RELEVANT**

| Category* | Citation of document, with indication, where appropriate, of the relevant passages | Relevant to claim No. |
|---|---|---|
| A | KR 10-2020-0010995 A (LG CHEM, LTD.) 31 January 2020 (2020-01-31)<br>See abstract; paragraphs [0056] and [0079]-[0090]; and claims 1 and 5. | 1-14 |
| A | KR 10-2014-0111997 A (LAM RESEARCH CORPORATION) 22 September 2014 (2014-09-22)<br>See entire document. | 1-14 |
| A | KR 10-0277795 B1 (SAMSUNG SDI CO., LTD.) 01 February 2001 (2001-02-01)<br>See entire document. | 1-14 |
| A | KR 10-2020-0071018 A (LG CHEM, LTD.) 18 June 2020 (2020-06-18)<br>See entire document. | 1-14 |
| A | KR 10-2014-0045716 A (KONKUK UNIVERSITY INDUSTRIAL COOPERATION CORP) 17 April 2014 (2014-04-17)<br>See entire document. | 1-14 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 March 2023** | **15 March 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2022/019769**

| Patent document cited in search report | Publication date (day/month/year) | Patent family member(s) | Publication date (day/month/year) |
|---|---|---|---|
| KR 10-2020-0010995 A | 31 January 2020 | None | |
| KR 10-2014-0111997 A | 22 September 2014 | CN 104046981 A | 17 September 2014 |
| | | CN 104046981 B | 17 January 2020 |
| | | KR 10-2218717 B1 | 22 February 2021 |
| | | TW 201500184 A | 01 January 2015 |
| | | TW I629167 B | 11 July 2018 |
| | | US 2014-0272459 A1 | 18 September 2014 |
| | | US 9337002 B2 | 10 May 2016 |
| KR 10-0277795 B1 | 01 February 2001 | KR 10-2000-0025555 A | 06 May 2000 |
| KR 10-2020-0071018 A | 18 June 2020 | CN 113646924 A | 12 November 2021 |
| | | EP 3879603 A1 | 15 September 2021 |
| | | JP 2022-513765 A | 09 February 2022 |
| | | US 2022-0029145 A1 | 27 January 2022 |
| | | WO 2020-122511 A1 | 18 June 2020 |
| KR 10-2014-0045716 A | 17 April 2014 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020210174108
- KR 1020160026306 A